Europäisches Patentamt

European Patent Office

Office européen des brevets

(19)

(11) **EP 0 723 160 B1**

(12)

# FASCICULE DE BREVET EUROPEEN

(45) Date de publication et mention
de la délivrance du brevet:
**29.12.1997   Bulletin 1997/52**

(51) Int Cl.⁶: **G01R 19/165**

(21) Numéro de dépôt: **96470001.7**

(22) Date de dépôt: **17.01.1996**

(54) **Circuit de détection de tension compensé en technologie et en température**

Für Technologie und Temperatur kompensierte Spannungsdetektionsschaltung

Voltage detection circuit compensated for technology and for temperature

(84) Etats contractants désignés:
**DE FR GB IT**

(30) Priorité: **23.01.1995   FR 9500862**

(43) Date de publication de la demande:
**24.07.1996   Bulletin 1996/30**

(73) Titulaire: **SGS-THOMSON MICROELECTRONICS S.A.**
**94250 Gentilly (FR)**

(72) Inventeur: **Drouot, Sylvie**
**F-57000 Metz (FR)**

(74) Mandataire: **Schmit, Christian Norbert Marie**
**Cabinet Ballot-Schmit,**
**18 Place du Forum**
**57000 Metz (FR)**

(56) Documents cités:
**EP-A- 0 093 606            US-A- 3 628 070**
**US-A- 4 716 323            US-A- 5 196 833**

## Description

L'invention concerne un circuit de détection de tension compensé en technologie et en température. Typiquement, le but d'un circuit de détection en tension est de fournir une information sur la valeur d'une tension variable donnée. L'invention trouve par exemple une application dans tout circuit intégré en semiconducteur, tel qu'une mémoire électriquement programmable, comprenant un circuit générateur de tension produisant une tension qu'on souhaite réguler.

Pour programmer les mémoires électriquement programmables en circuit intégré, il est généralement nécessaire de disposer dans le circuit intégré d'une tension dite de programmation, VB, qui est supérieure à la tension d'alimentation normale VCC du circuit. Par exemple, VCC est égale à 5 volts et VB est égale à 7 volts ou plus.

Dans certaines mémoires, la tension de programmation VB est produite à l'intérieur du circuit intégré, à partir de la tension d'alimentation normale VCC. On utilise pour cela un circuit multiplicateur de tension à capacité commutée, appelé également communément pompe de charge, qui reçoit VCC et produit la tension VB. Les circuits multiplicateurs de tension utilisent typiquement des diodes, des condensateurs et un signal d'horloge. Par exemple, dans un premier temps, on charge un premier condensateur à VCC, puis on le décharge dans un deuxième condensateur. Puis on recommence la même opération et la tension aux bornes du second condensateur augmente progressivement. La tension de programmation VB va tendre asymptotiquement vers une valeur limite, cette valeur limite étant égale à un multiple de la tension d'alimentation VCC (deux fois VCC dans l'exemple décrit précédemment, qui correspond à un circuit dit doubleur de Schenkel).

Ce type de montage pose un problème si la valeur de la tension de programmation que l'on souhaite atteindre est égale à la valeur limite. En effet, la tension produite augmente de moins en moins rapidement au fur et à mesure que le deuxième condensateur se charge. Pour limiter le temps d'établissement de la tension produite à la valeur souhaitée, on est donc amené à surdimensionner la pompe de charge, c'est à dire à fixer une valeur limite supérieure à la valeur de tension produite souhaitée. Il est alors nécessaire de placer en sortie de la pompe un régulateur de tension qui limite la tension produite à la valeur souhaitée. Par ailleurs, si la valeur souhaitée n'est pas un multiple de la valeur de la tension d'alimentation, la présence d'un tel circuit régulateur s'impose.

Il existe deux manières de réguler la tension produite :

- sans arrêter la pompe, en consommant la surcharge fournie par la pompe, une fois la valeur souhaitée atteinte, en connectant la sortie de la pompe à une masse par le biais d'une ou plusieurs diodes par exemple,
- en arrêtant la pompe lorsque la valeur souhaitée est atteinte et en la redémarrant lorsque la tension aux bornes du second condensateur devient trop basse.

La deuxième solution a l'avantage de consommer moins. La tendance actuelle étant précisément de diminuer les valeurs de tension d'alimentation et de courant consommé dans les circuits électroniques, elle est particulièrement intéressante.

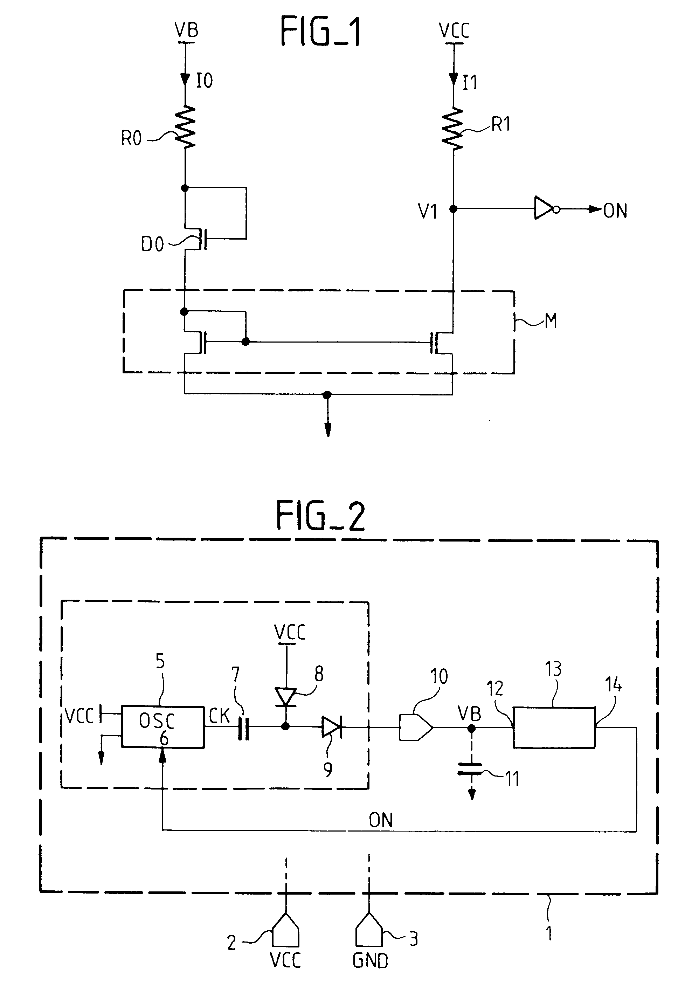

Pour arrêter une pompe de charge, on peut utiliser un circuit de détection tel que celui illustré à la figure 1.

Ce circuit de détection comprend :

- une première branche résistive comprenant une résistance R0, cette branche recevant la tension produite VB pour produire un courant I0,
- un miroir de courant M relié à la première branche résistive pour produire un courant de référence $I1 = k * I0$, proportionnel au courant I0,
- une deuxième branche résistive, reliée au miroir de courant, et comprenant une résistance R1, pour produire une tension de référence $V1 = VCC - R1 * I1$,
- un circuit logique (en pratique un inverseur) recevant la tension V1 et produisant un signal binaire ON, pour arrêter ou mettre en marche la pompe de charge.

Le signal ON changera d'état logique pour une valeur de tension produite VBM telle que $V1 = VCC/2$.

On a $VBM = (R0 * VCC)/(2 * k * R1) + x * V_{tn}$, avec x un entier supérieur ou égal à 1, et $V_{tn}$ la tension de seuil d'un transistor MOS de type N (en supposant que le miroir de courant est réalisé à l'aide de transistor MOS de type N, et que l'on décale la tension de basculement VBM à l'aide de diodes de type N, pour minimiser la consommation dans la première branche résistive).

Ce type de circuit pose un problème vis à vis des variations, ou dérives, des caractéristiques électroniques des composants.

Les circuits intégrés sont sujets à trois types de variation :

- les variations de tension d'alimentation (qui sont en principe indépendantes des circuits alimentés, et ne seront donc pas traitées ici),

- les variations relatives aux procédés de fabrication des circuits, dites variations en technologie,
- les variations relatives à la température à laquelle sont soumis les circuits en fonctionnement, dites variations en température.

Les variations en technologie dépendent principalement des tolérances lithographiques de fabrication. Elles sont d'autant plus sensibles pour un composant que ses dimensions sont petites. Ainsi, en technologie MOS (Métal-Oxyde-Semiconducteur), elles concernent plus particulièrement les transistors, dont les dimensions de couche d'oxyde (épaisseur, longueurs et largeurs effectives) sont faibles.

Les variations en température sont liées principalement aux caractéristiques d'implantation (type d'implantation, taux d'implantation etc.). Elles touchent aussi bien les composants passifs (résistances) que les composants actifs.

Il est généralement primordial de prévoir, pour un circuit donné, les marges des variations pouvant affecter ce circuit, afin de vérifier que les variations ne risquent pas de modifier de manière préjudiciable leur fonctionnement. Pour ce faire, on procède généralement à partir de calculs et/ou de l'expérience du concepteur, à une modélisation des circuits en fonction des variations pouvant les affecter. Cette modélisation est le plus souvent représentée sous forme graphique par des courbes gaussiennes caractérisées par une valeur typique (c'est la valeur la plus probable, sur laquelle est centré la courbe gaussienne), et un écart type. A partir de cette modélisation, on peut prévoir les variations de caractéristiques de fonctionnement du circuit telles que la consommation, le temps de réponse etc.

Dans un circuit tel que celui illustré figure 1, on pourra éventuellement envisager de compenser les variations en température, pour obtenir une valeur de basculement VBM relativement stable sur la plage d'utilisation garantie par le fabriquant (généralement de l'ordre de - 45 à + 125 °C). Il suffit alors de choisir des résistances R0 et R1 ayant des coefficients de température adéquats pour compenser les variations des valeurs de R0, R1 et $V_{tn}$.

Le choix des résistances (type de technologie et valeur en Ohms) sera lié à la connaissance de valeurs de dispersion statistique. Typiquement, si la température augmente, les valeurs réelles des résistances diffusées et pincées ont tendance à augmenter, alors que les tensions de seuil des transistors ont tendance à diminuer. Si le coefficient de température de R0 est plus positif que celui de R1, le ratio R0/R1 aura tendance à augmenter avec la température, et à compenser ainsi la diminution de $V_{tn}$. Globalement on pourra atténuer la variation en température de la valeur de VBM.

Par contre, on ne pourra pas compenser les variations en technologie de la tension de seuil $V_{tn}$. Par rapport à sa valeur typique, $V_{tn}$ sera donc entachée d'une erreur constante, qui se répercutera sur sa variation en température.

On aura VBM = (R0(T) * VCC)/(2 * k * R1(T)) + x * $V_{tn}$(T, P) avec

$$R0\ (T) = R0\ (T_{ref}) * (1 + k0 * (T - T_{ref})),$$

$$R1(T) = R1(T_{ref}) * (1 + k1 * (T - T_{ref})),$$

$$V_{tn}(T, P) = (V_{tn}(P_{ref}, T_{ref}) + \Delta V_{tn}\ (P, T_{ref})) + \Delta V_{tn}(P, T),$$

avec

$T_{ref}$ une température de référence (généralement 25 °C), k0 et k1 les coefficients de température des résistances R0 et R1, $V_{tn}(P_{ref}, T_{ref})$ la tension de seuil correspondant à la température de référence et à la valeur typique en fabrication, $\Delta V_{tn}(P, T_{ref})$ l'erreur induite par la fabrication (erreur constante à température donnée), et $\Delta V_{tn}\ (P, T)$ l'erreur en température associé à la valeur réelle de $V_{tn}$ ($V_{tn}$ typique + erreur de fabrication).

Un but de l'invention est de proposer un circuit de détection fonctionnant de manière analogue à celui de la figure 1, permettant de compenser également les variations en technologie de la tension de seuil.

Un circuit correspondant à celui de la figure 1 est p. ex. connu du document EP-A-0 093 606 ou encore du document US-A-4 716 323.

Ainsi, l'invention propose un circuit de détection de tension pour fournir un signal binaire dont l'état est représentatif de la valeur d'une tension interne, différente de la tension d'alimentation dudit circuit, comprenant une première branche résistive recevant la tension interne pour produire un courant de base, des moyens d'amplification de courant pour produire un courant de référence proportionnel au courant de base, une deuxième branche résistive pour produire une tension de référence représentative du courant de référence , une source de tension pour produire une tension de commande à partir de la tension de référence, et un circuit logique pour produire le signal binaire à partir de la tension de commande.

Le circuit revendiqué propose donc d'ajouter un étage supplémentaire dans le circuit de détection qui permettra de compenser les variations en technologie du circuit de la figure 1.

D'autres avantages et particularités apparaîtront à à la lecture de la description détaillée qui suit d'un exemple de réalisation de l'invention, donnée à titre indicatif et nullement limitatif, et faite en référence aux dessins annexés dans lesquels :

- la figure 1 représente un circuit de détection suivant l'état de l'art,
- la figure 2 représente un circuit comprenant un circuit de détection selon l'invention,
- la figure 3 représente le circuit de détection du circuit de la figure 2.

On supposera que les circuits illustrés sont réalisés en technologie MOS.

La figure 2 représente un circuit intégré 1 comprenant :

- une borne d'alimentation 2 pour fournir une tension d'alimentation VCC,
- une borne de référence 3 pour fournir une tension de base GND (en pratique la borne 3 est connectée à une masse),
- une pompe de charge 4 pour produire une tension VB, dite interne, à partir de la tension d'alimentation VCC,
- un circuit de détection 13 qui reçoit sur une entrée 12 la tension interne VB, et qui produit sur une sortie 14 un signal binaire ON dont l'état logique est fonction de la valeur de la tension interne VB.

Dans l'exemple décrit, la pompe de charge 4 double la tension d'alimentation VCC. Cette pompe de charge 4 comporte un oscillateur 5 pour fournir un signal d'horloge CK. Ce signal est appliqué à une borne d'un condensateur 7. L'autre borne de ce condensateur 7 est connectée d'une part à la borne d'alimentation 2 par le biais d'une diode 8, et d'autre part à une sortie 10 par le biais d'une diode 9. Cette borne de sortie 10 est connectée au premier pôle d'une condensateur de sortie 11. Le condensateur de sortie 11 a son autre pôle connecté à la borne de référence 3.

On considère ici que le condensateur de sortie 11 constitue l'équivalent d'un circuit capacitif alimenté par la pompe de charge 4, ce qui explique que cette pompe ne comprend qu'un seul condensateur 7. La tension interne VB est la tension présente sur la sortie 10 de la pompe de charge 4.

Pour arrêter la pompe de charge 4, on suppose que l'oscillateur 5 comprend une entrée 6 pour recevoir le signal logique ON de telle manière que l'oscillateur 7 fonctionne si ON est à l'état logique 1 et s'arrête s'il est à l'état logique 0. Si ON = 0, le signal d'horloge CK sera constant et au potentiel de la masse et ne pourra donc pas charger le condensateur 7.

La sortie 10 est connectée à l'entrée 12 du circuit de détection 13.

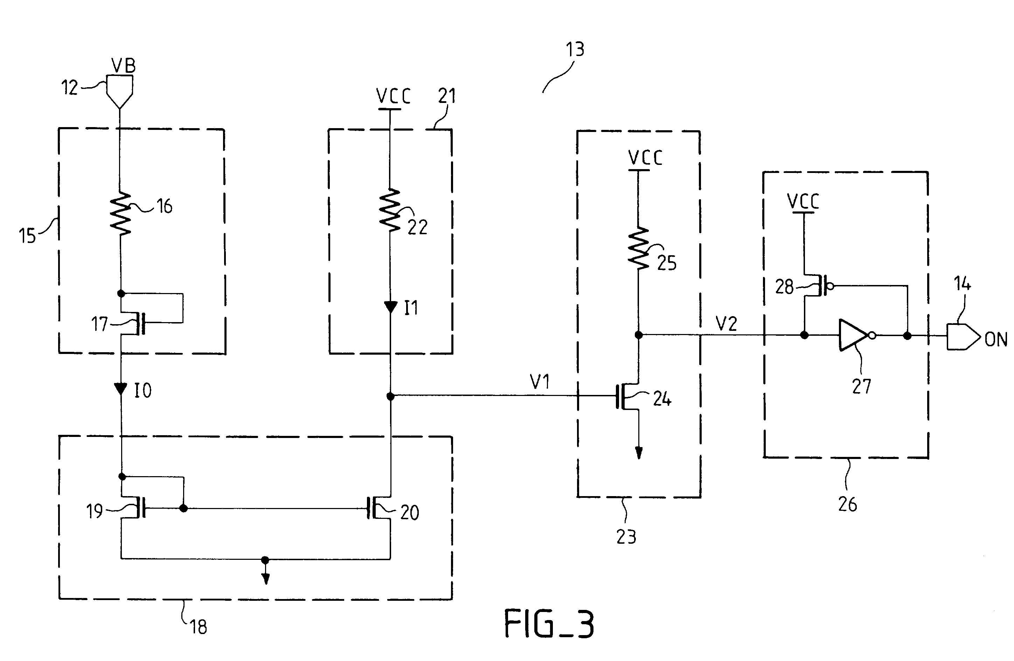

Le circuit de détection 13, illustré figure 3, comprend :

- une première branche résistive 15, cette branche 15 recevant la tension interne VB pour produire un courant I0, dit de base,
- un miroir de courant 18 relié à la première branche résistive 15 pour produire un courant I1, dit de référence, proportionnel au courant de base I0,
- une deuxième branche résistive 21, reliée au miroir de courant 18, pour produire une tension V1, dite de référence, représentative du courant de référence I1,
- une source de tension 23 recevant la tension de référence V1 et produisant une tension V2, dite de commande, et
- un circuit logique 26 recevant la tension de commande V2 et produisant le signal binaire ON.

La première branche résistive 15 comprend une résistance 16, et une diode. La résistance 16 a un premier pôle relié à l'entrée 12 du circuit 13. On notera R0 sa valeur en Ohms. Son deuxième pôle est relié au drain d'un transistor à effet de champ 17, de type NMOS, monté en diode (son drain est relié à sa grille de commande).

Le miroir de courant 18 est formé par un premier et un deuxième transistors 19 et 20 dits d'amplification. Les transistors d'amplification 19 et 20 sont des transistors à effet de champ de type NMOS, c'est à dire de même type que le type du transistor 17. Le drain du premier transistor d'amplification 19 est connecté à sa grille de commande, à la grille de commande du deuxième transistor d'amplification 20, et à la source du transistor 17. Les sources des premier et deuxième transistors d'amplification 19 et 20 sont connectées à la masse.

La deuxième branche résistive 21 comprend une résistance 22. La résistance 22 a un premier pôle relié à la borne d'alimentation 2. On notera R1 sa valeur en Ohms. Son deuxième pôle est relié au drain du deuxième transistor d'amplification 20.

On a :

$$I0 = (VB - 2 * V_{tn})/R0,$$

avec $V_{tn}$ la tension de seuil d'un transistor de type NMOS,

$$I1 = m * I0,$$

avec m le gain du miroir de courant, et

$$V1 = VCC - m * I0 * R1,$$

avec V1 la tension au niveau du drain du transistor d'amplification 20.

La source de tension 23 comprend un transistor à effet de champ 24, de type NMOS, et une résistance 25. Le transistor 24 de la source de tension 23 est donc de même type que les transistors d'amplification 19 et 20 du miroir de courant 18 et que du transistor 17 monté en diode. La grille de commande du transistor 24 est reliée au drain du deuxième transistor d'amplification 20. Elle reçoit la tension de référence V1. La source du transistor 24 est reliée à la masse. Son drain est relié à la borne d'alimentation 2 par le biais de la résistance 25. Le canal du transistor 24 est donc monté en série avec la résistance 25.

On notera R2 la valeur en Ohms de la résistance 25 et I2 le courant parcourant la résistance 25. V2 est le potentiel présent au niveau du drain du transistor 24.

On a :

$$V2 = VCC - R2 * I2,$$

$$I2 = K * (V1 - V_{tn})^2,$$

avec K le facteur de transconductance du transistor 24.

En combinant les équations ci-dessus, on obtient :

$$V2 = VCC - R2 * K * [VCC - (VB - 2 * V_{tn}) * m * R1/R0 - V_{tn}]^2.$$

Dans l'exemple décrit, le circuit logique 26 comprend un inverseur de type CMOS classique 27 et un transistor à effet de champ 28, de type PMOS. La source de ce transistor 28 est reliée à la borne d'alimentation 2. Son drain est relié à l'entrée de l'inverseur 27. Sa grille de commande est reliée à la sortie de ce même inverseur 27. La sortie de l'inverseur 27 est reliée à la sortie 14 du circuit de détection 13. C'est cet inverseur qui produit le signal binaire ON. La présence du transistor 28 n'est en toute rigueur pas indispensable. Il permet de garantir que le signal binaire ON aura un comportement stable, c'est à dire non flottant.

Déterminons maintenant la valeur de tension interne VBM telle que le signal ON passe d'un état logique à l'autre. Le basculement de l'état du signal ON se produira typiquement pour V2 = VCC/2.

On en déduit :

$$VBM = [VCC - (VCC/(2 * R2 * K))^{1/2}] * R0/(m * R1) + [2 - R0/(m * R1)] * V_{tn}.$$

Pour VB < VBM on aura ON = 1.
Pour VB > VBM on aura ON = 0.

On a supposé qu'un courant I0 parcourait la première branche résistive 15, c'est à dire que VBM > 2 * $V_{tn}$. Si on désire produire une tension VB inférieure à 2 * $V_{tn}$, on pourra éliminer le transistor 17, placé dans le seul but de retarder l'apparition du courant de base I0 dans la première branche résistive 15. Il est en effet particulièrement important de minimiser le courant prélevé I0 en sortie de la pompe de charge 4 par le circuit de détection 13, car le principe de fonctionnement d'une telle pompe de charge est basé sur le transfert de charge entre condensateurs. Le but premier de la présence de la pompe de charge n'est pas normalement d'alimenter le circuit de détection 13. On peut également minimiser la valeur du courant de base I0 en choisissant une valeur de résistance élevée dans la première branche résistive 15. On se heurte alors à un problème d'encombrement excessif. La présence d'une ou plusieurs diodes permet de minimiser cet encombrement, à valeur de courant de base identique pour une valeur de tension interne donnée. Ainsi, on ne prélevera pas un courant important sur le condensateur de sortie 11 et le temps de monté de la tension interne VB n'augmentera pas significativement (par rapport au temps de montée si seul le condensateur de sortie 11 est connecté à la sortie 10 de la pompe de charge 4).

Par ailleurs, il convient d'éviter une variation lente de la tension de commande V2 autour de la tension de basculement de l'inverseur 27. On choisira ainsi de préférence un gain m important et/ou des valeurs de résistance importantes dans la deuxième branche résistive 21 et la source de tension 23, pour produire une tension de commande V2 variant beaucoup en fonction du courant de base I0.

On va maintenant décrire le comportement du circuit de détection 13 en fonction des variations qui pourraient l'affecter, tout d'abord du fait des tolérances géométriques de fabrication, et ensuite du fait de l'environnement d'utilisation.

Variations en technologie.

Les composants principalement affectés par ce type de variation sont les transistors.

Pour un transistor MOS, on a $K = (\mu_n * C_{ox} * W/L)/2$, avec $\mu_n$ la mobilité des électrons, $C_{ox}$ la capacité de l'oxyde et W/L le rapport de géométrie de la grille du transistor.

En première approximation, on pourra considérer les variations en technologie des valeurs des résistances comme négligeables. Cela sera d'autant plus vrai que les dimensions de ces résistances seront importantes.

Supposons que l'épaisseur d'oxyde soit inférieure à l'épaisseur typique. Par rapport au valeurs attendues, K sera supérieur et $V_{tn}$ sera inférieure.

$[VCC - (VCC/(2 * R2 * K))^{1/2}] * R0/ (m * R1)$ va être supérieure à ce qui est attendu et $[2 - R0/(m * R1)] * V_{tn}$ va être inférieure à ce qui est attendu.

Globalement, on pourra compenser la diminution de $V_{tn}$ par l'augmentation de K, en fonction de VCC, et en choisissant des valeurs R0/R1, m et R2 appropriées.

Symétriquement, on pourra compenser l'augmentation de $V_{tn}$ par la diminution de K si la valeur de l'épaisseur d'oxyde est supérieure à l'épaisseur typique.

On aura intérêt, par soucis de simplification, à choisir de préférence des transistors de même type (NMOS dans l'exemple traité) pour réaliser la diode de la première branche résistive 15, le miroir de courant 18 et la source de tension 23. En ce qui concerne la diode, le choix d'un transistor de type NMOS a également pour conséquence d'augmenter la valeur de VB à partir de laquelle un courant I0 apparait dans la branche résistive 15, et donc de diminuer la consommation globale du circuit 1.

Par rapport au circuit de l'état de l'art (figure 1), la présence de la source de tension 23 permet de compenser les variations de tension de seuil des transistors 17, 19 et 20.

En ce qui concerne l'inverseur 27 du circuit logique 26 les variations en technologie affectent les deux transistors le constituant.

Soit $V_{it}$ la tension de basculement de cet inverseur.

On a $V_{it} = [[(K_p/K_n)^{1/2} * (VCC - V_{tp})] + V_{tn}] * (1 + (Kp/K_n)^{1/2})^{-1}$, avec $K_p$ et $K_n$ les facteurs de transconductance des transistors PMOS et NMOS, et $V_{tp}$ la tension de seuil d'un transistor PMOS.

Dans le calcul de VBM, on a supposé $V_{tp} = - V_{tn}$ et $K_p = K_n$. En tenant compte de la présence de l'inverseur 27 dans le dimensionnement de la source de tension 23, on pourra obtenir une valeur de tension de basculement $V_{it}$ stable en technologie.

Variations en température.

Tous les composants du circuit de détection 13 sont affectés par ce type de variation.

Supposons que la température augmente. La tension de seuil $V_{tn}$ aura tendance à diminuer, le facteur K aura tendance à diminuer, et les valeurs des résistances auront tendance à augmenter (exception faite des résistances métalliques Nickel-Chrome s'il y en a).

En choisissant la résistance 25 de telle manière que son coefficient de température k2 soit positif, et la résistance 16 de telle manière que son coefficient de température k0 soit plus positif que le coefficient de température k1 de la résistance 22, on pourra :

- compenser la diminution de K par l'augmentation de R2, si le produit K * R2 a une valeur relativement indépendante de la température,
- compenser la diminution de $[2 - R0/(m * R1)] * V_{tn}$ par l'augmentation de $[VCC - (VCC/(2 * R2 * K))^{1/2}] * R0/(m * R1)$.

Par exemple, les résistances 16, 22, 25 seront des résistances diffusées telles que :

- la résistance 16 soit de type N,

- la résistance 22 soit de type N+, c'est à dire réalisée à partir d'une diffusion d'un dopant avec un taux de dopage supérieur à celui du dopant utilisé pour réaliser la résistance 16.

Les résistances 16, 22 et 25 pourront être formées de plusieurs résistances de types différents, montées en série. Ainsi, par exemple, elles pourront être formées de résistances diffusées montées en série ayant des caractéristiques de dopage, type de dopant et/ou taux de dopage, différentes. Elles pourront aussi être formées de résistances de différents types de réalisation (diffusées, pincées, métalliques) montées en série. En réalisant ainsi les résistances 16, 22 et 25, on obtiendra des valeurs de coefficients de température adaptées aux valeurs de tension produites, et aux paramètres technologiques de réalisation des transistors, qui déterminent les variations en température de K et de $V_{tn}$.

Dans la description, il ne faut pas comprendre les termes de résistance 16, résistance 22 et résistance 25 dans un sens restrictif. Ces résistances 16, 22 et 25 pourront être :

- des résistances physiquement réalisées,
- des résistances équivalentes à plusieurs résistances physiquement réalisées et montées en série,
- de manière plus générale, des circuits résistifs caractérisés par un coefficient de température et une valeur en Ohms donnés.

Il conviendra seulement de s'assurer que :

- le coefficient de température de la résistance 25 de la source de tension 23 est positif, et
- le coefficient de température de la première branche résistive 15, c'est à dire celui de la résistance 16, est plus positif que le coefficient de température de la deuxième branche résistive 21, c'est à dire que celui de la résistance 22.

On pourra ainsi compenser la variation en température de VBM.

On notera que la source de tension 23 compense, indépendamment des autres parties du détecteur, la variation en température de V2. En effet K et R2 varient en sens opposés, en fonction de la température.

En ce qui concerne l'inverseur 27, on observera un déplacement de la tension de basculement $V_{it}$ vers le bas. On en tiendra compte dans le choix des coefficients de température des résistances des branches résistives.

On notera que la description détaillée ci-dessus a été faite en référence à une application avantageuse de l'invention dans un circuit intégré de type mémoire électriquement programmable. Il ne s'agit bien sûr que d'un exemple particulier, non limitatif. La pompe de charge pourrait très bien être extérieure au circuit intégré. Le signal binaire produit par le circuit de détection ne sera pas non plus obligatoirement utilisé pour commander un circuit d'alimentation, mais pourra être utilisé plus généralement pour fournir une information sur la valeur d'une tension. Le circuit de détection tel que décrit pourra aussi très bien être réalisé en composants discrets sans que l'on sorte du cadre de l'invention. De même, ce circuit pourra très bien être réalisé dans une technologie différente de la technologie MOS.

**Revendications**

1. Circuit de détection de tension (13) pour fournir un signal binaire (ON) dont l'état est représentatif de la valeur d'une tension interne (VB) différente de la tension d'alimentation (Vcc) dudit circuit, comprenant:

   - une première branche résistive (15) recevant la tension interne (VB) pour produire un courant de base (I0),
   - des moyens d'amplification de courant (18) pour produire un courant de référence (I1) proportionnel au courant de base (I0),
   - une deuxième branche résistive (21) pour produire une tension de référence (V1) représentative du courant de référence (I1),
   - une source de tension (23) pour produire une tension de commande (V2) à partir de la tension de référence (V1), et
   - un circuit logique (27) pour produire le signal binaire (ON) à partir de la tension de commande (V2).

2. Circuit selon la revendication 1, caractérisé en ce que la source de tension (23) comprend au moins une résistance (25) ayant un coefficient de température (k2) positif.

3. Circuit selon la revendication 2, caractérisé en ce que la source de tension (23) comprend un transistor à effet de champ (24) dont le canal est monté en série avec la résistance (25), et recevant sur sa grille de commande la tension de référence (V1).

4. Circuit selon la revendication 3, caractérisé en ce que la valeur du produit du coefficient de température (k2) de la résistance (25) de la source de tension (23) et du facteur de transconductance (K) du transistor (24) de cette source de tension est relativement indépendante de la température.

5. Circuit selon l'une des revendications 2 à 4, caractérisé en ce que la résistance (25) de la source de tension (23) est formée de résistances de types différents, montées en série.

6. Circuit selon l'une des revendications 3 à 5, caractérisé en ce que les moyens d'amplification de courant comprennent un miroir de courant (18) formé de transistors d'amplification (19, 20) de même type que celui du transistor (24) de la source de tension (23).

7. Circuit selon l'une des revendications 3 à 6, caractérisé en ce que la première branche résistive (15) comprend au moins une diode de décalage réalisée à l'aide d'un transistor (17) de même type que celui du transistor (24) de la source de tension (23).

8. Circuit selon l'une des revendications 1 à 7, caractérisé en ce que le coefficient de température (k0) de la première branche résistive (15) est supérieur au coefficient de température (k1) de la deuxième branche résistive (21), les deux coefficients étant positifs.

9. Circuit selon l'une des revendications 1 à 8, caractérisé en ce que la première branche résistive (15) et/ou la deuxième branche résistive (21) comprennent des résistances de types différents, montées en série.

**Patentansprüche**

1. Spannungserfassungsschaltkreis (13) zum Ausgeben eines binären Signals (ON), dessen Zustand den Wert einer anderen internen Spannung (VB) als der Versorgungsspannung (VCC) des Schaltkreises wiedergibt, der umfaßt:

   - einen ersten Widerstandszweig (15), an dem die interne Spannung (VB) anliegt, so daß ein Basisstrom (I0) fließt,
   - Stromverstärkungsvorrichtungen (18), so daß ein Referenzstrom (I1) proportional zu dem Basisstrom (I0) fließt,
   - einen zweiten Widerstandszweig (21), so daß eine Referenzspannung (VI) erzeugt wird, die den Referenzstrom (I1) widerspiegelt,
   - eine Spannungsquelle (23), so daß eine Steuerspannung (V2) aus der Referenzspannung (V1) gebildet wird, und
   - einen Logikschaltkreis (27), so daß das Binärsignal (ON) aus der Steuerspannung (V2) gebildet wird.

2. Schaltkreis nach Anspruch 1, dadurch gekennzeichnet, daß die Spannungsquelle (23) wenigstens einen Widerstand (25) mit einem positiven Temperaturkoeffizienten (k2) umfaßt.

3. Schaltkreis nach Anspruch 2, dadurch gekennzeichnet, daß die Spannungsquelle (23) einen Feldeffekttransistor (24) umfaßt, dessen Kanal in Serie mit dem Widerstand (25) liegt und an dessen Steuergate die Referenzspannung (V1) anliegt.

4. Schaltkreis nach Anspruch 3, dadurch gekennzeichnet, daß der Wert des Produktes aus dem Temperaturkoeffizienten (k2) des Widerstandes (25) der Spannungsquelle (23) und dem Vorwärtsleitwertfaktor (K) des Transistors (24) dieser Spannungsquelle relativ unabhängig von der Temperatur ist.

5. Schaltkreis nach einem der Ansprüche 2 bis 4, dadurch gekennzeichnet, daß der Widerstand (25) der Spannungsquelle (23) aus Widerständen unterschiedlicher Typen besteht, die in Reihe geschaltet sind.

6. Schaltkreis nach einem der Ansprüche 3 bis 5, dadurch gekennzeichnet, daß die Stromverstärkungsvorrichtungen einen Stromspiegel (18) umfassen, der aus Verstärkungstransistoren (19, 20) vom gleichen Typ wie der Transistor (24) der Spannungsquelle (23) besteht.

7. Schaltkreis nach einem der Ansprüche 3 bis 6, dadurch gekennzeichnet, daß der erste Widerstandszweig (15) wenigstens eine Verschiebediode in Form eines Transistors (17) vom gleichen Typ wie der Transistor (24) der Spannungsquelle (23) umfaßt.

8. Schaltkreis nach einem der Ansprüche 1 bis 7, dadurch gekennzeichnet, daß der Temperaturkoeffizient (k0) des ersten Widerstandszweiges (15) größer als der Temperaturkoeffizient (k1) des zweiten Widerstandszweiges (21) ist, wobei beide Koeffizienten positiv sind.

9. Schaltkreis nach einem der Ansprüche 1 bis 8, dadurch gekennzeichnet, daß der erste Widerstandszweig (15) und/oder der zweite Widerstandszweig (21) Widerstände unterschiedlicher Typen umfaßt, die in Serie geschaltet sind.

## Claims

1. Voltage detection circuit (13) for supplying a binary signal (ON) whose state represents the value of an internal voltage (VB) different from the supply voltage (VCC) of the said circuit, comprising:

   - a first resistive arm (15) receiving the internal voltage (VB) in order to produce a base current (I0),

   - current amplification means (18) for producing a reference current (I1) proportional to the base current (I0),

   - a second resistive arm (21) for producing a reference voltage (V1) representing the reference current (I1),

   - a voltage source (23) for producing a control voltage (V2) from the reference voltage (V1), and

   - a logic circuit (27) for producing the binary signal (ON) from the control voltage (V2).

2. Circuit according to Claim 1, characterised in that the voltage source (23) comprises at least one resistor (25) having a positive temperature coefficient (k2).

3. Circuit according to Claim 2, characterised in that the voltage source (23) comprises a field effect transistor (24) whose channel is connected in series with the resistor (25), and receiving the reference voltage (V1) at its control gate.

4. Circuit according to Claim 3, characterised in that the value of the product of the temperature coefficient (k2) of the resistor (25) of the voltage source (23) and the transconductance factor (K) of the transistor (24) of this voltage source is relatively independent of the temperature.

5. Circuit according to one of Claims 2 to 4, characterised in that the resistor (25) of the voltage source (23) is formed by resistors of different types, connected in series.

6. Circuit according to one of Claims 3 to 5, characterised in that the current amplification means comprise a current mirror (18) formed by amplification transistors (19, 20) of the same type as the transistor (24) of the voltage source (23).

7. Circuit according to one of Claims 3 to 6, characterised in that the first resistive arm (15) comprises at least one shift diode produced by means of a transistor (17) of the same type as the transistor (24) of the voltage source (23).

8. Circuit according to one of Claims 1 to 7, characterised in that the temperature coefficient (k0) of the first resistive arm (15) is greater than the temperature coefficient (k1) of the second resistive arm (21), the two coefficients being positive.

9. Circuit according to one of Claims 1 to 8, characterised in that the first resistive arm (15) and/or the second resistive arm (21) comprise resistors of different types, connected in series.

# FIG_1

VB

I0

R0 ⌇

D0

M

VCC

I1

R1 ⌇

V1 ───▷○──→ ON

# FIG_2

VCC

5 OSC CK 6

7

8

VCC

9

10

VB 12 13 14

11

ON

2 VCC

3 GND

1

FIG_3